# EUROPEAN PATENT SPECIFICATION

(11) **EP 2 436 118 B1**
(45) Date of publication and mention of the grant of the patent: **10.08.2016**
(21) Application number: 11743983.6
(22) Date of filing: 29.06.2011
(51) Int. Cl.: H03K 17/955, H03K 17/96

(54) **SENSOR DEVICE AND METHOD FOR THE DETECTION OF A GRIPPING OF A HAND-HELD DEVICE AS WELL AS A HAND-HELD DEVICE**
SENSORVORRICHTUNG UND VERFAHREN ZUR ERKENNUNG DER ERGREIFUNG EINER TRAGBAREN VORRICHTUNG SOWIE TRAGBARE VORRICHTUNG
DISPOSITIF DE CAPTEUR ET PROCÉDÉ DE DÉTECTION DE PRÉHENSION D'UN DISPOSITIF PORTATIF, ET DISPOSITIF PORTATIF

(30) Priority: 05.07.2010 DE 102010030959
(43) Date of publication of application: 04.04.2012
(73) Proprietor: Microchip Technology Germany II GmbH & Co. KG, 82205 Gilching (DE)
(72) Inventor: STEFFENS, Holger, 81377 München (DE); FASSHAUER, Peter, 85579 Neubiberg (DE); KALTNER, Claus, 85221 Dachau (DE)
(74) Representative: Grubert, Andreas
(86) International application number: PCT/EP2011/060968
(87) International publication number: WO 2012/004176

(56) References cited:
- WO-A2-01/06472
- WO-A2-2009/130165

## Description

### Field of the invention

The present invention relates to a sensor device for the detection of a gripping of a hand-held device with one hand. Furthermore, the invention relates to a method for the detection of a gripping of a hand-held device with one hand, wherein the hand-held device comprises a sensor device according to the present invention for the detection of the gripping. Furthermore, the invention relates to a hand-held device comprising a sensor device according to the present invention.

### Background of the invention

It has long been desired to reliably detect a gripping of the hand-held device with one hand, particularly with regard to electrical hand-held devices. For reliably detecting a gripping of a hand-held device with one hand, the hand-held device, such as a cell phone, can be provided with additional functions being performed depending on whether the hand-held device is gripped with one hand. For example, a cell phone can be turned on and/or the key lock can be unlocked when it is gripped with one hand. When letting go of the cell phone, it can be turned off and/or the key lock can be activated.

A sensor device which can detect the approximation or touch of a hand-held device with one hand is known from GB 2 398 138 A. The sensor device comprises a capacitive sensor, which sets the hand-held device, such as a computer mouse, to an active mode in case of approximation or touch and automatically sets the computer mouse to a sleep mode when taking the hand off the computer mouse. The capacity of the capacitive sensor changing with the approximation is measured for the detection of the approximation to the computer mouse, wherein a predetermined capacity represents the switching threshold for a wake-up detector. Tests have shown that the wake-up detector mentioned in GB 2 398 138 A has the disadvantage that it does not reliably detect an approximation of a hand to the wake-up detector. In the most unfavorable case, the approximation of a hand to the wake-up detector is even wrongly detected. This is particularly the case when the change of the capacity of the capacitive sensor in case of a hand approximating to the sensor is only very low.

Another example of capacitive proximity sensor is disclosed in WO 01/06472.

### Object of the invention

Thus, the invention is based on the problem to provide solutions in order to at least partially avoid the disadvantages known from the state of the art and to achieve a precise and secure detection of a gripping of a hand-held device, particularly of an electrical hand-held device.

### Solution according to the present invention

According to the present invention, this object is achieved by means of a sensor device, a hand-held device comprising a sensor device according to the invention as well as a method for the detection of a gripping of a hand-held device by means of a sensor device according to the independent claims of the invention. Advantageous embodiments and developments of the invention are referred to in the respective dependent claims.

According to the present invention, a sensor device comprising at least one first electrode and at least one second electrode being coupled with an analysis device is provided. The at least one first electrode can be operated in a first operating mode. The at least one second electrode can be operated in the first operating mode and in a second operating mode. In the first operating mode, the capacitive coupling between the at least one first electrode and the at least one second electrode can be analyzed by the analysis device. In the second operating mode, a capacitive load of the at least one second electrode against a reference ground can be analyzed by the analysis device.

The at least one first electrode can be operated in the second operating mode. Thus, a gripping of a hand-held device can also be detected in the second operating mode.

It is advantageous if an alternating electrical signal can be applied to the second electrode in the first operating mode and in the second operating mode, wherein the capacitive coupling between the first electrode and the second electrode is represented by the electric current flowing in the first electrode.

An alternating electrical signal can be applied to the first electrode in the second operating mode, wherein a capacitive load of the at least one first electrode against a reference ground can be analyzed by the analysis device.

The analysis device can be configured to provide a sensor signal in each of the first operating mode and the second operating mode, which is indicative for the capacitive coupling between the first electrode and the second electrode or for the capacitive load of the first electrode and/or the second electrode, respectively.

The sensor device can be operated sequentially in the first operating mode and in the second operating mode.

The sensor device can be operated in parallel in the first operating mode and in the second operating mode.

The capacitive load to be analyzed in the second operating mode can be used as reference value for adjusting a sensitivity of the sensor device in the first operating mode.

It has proven advantageous when the sensor device comprises a third electrode, wherein an alternating electrical signal can be applied to the third electrode, having a phase and/or amplitude differing from the phase and/or the amplitude of the alternating electrical signal applied to the second electrode.

The sensor device can also comprise a third electrode and a fourth electrode, which can each have an alternating electrical signal applied to them. It is advantageous when the sensor device can be operated in a third operating mode, wherein the capacitive couplings between the first electrode and the third electrode and between the second electrode and the fourth electrode can be analyzed by the analysis device.

Furthermore, a hand-held device is provided, comprising at least a sensor device according to the present invention.

The first electrode and the second electrode are preferentially arranged relative to one another on the hand-held device in such a way that they are at least partially overlapped with one hand when gripping the hand-held device with one hand.

The first electrode and the second electrode can be arranged at two walls facing each other, preferably at two side walls of a housing of the hand-held device facing each other.

Furthermore, the invention relates to a method for the detection of a gripping of a hand-held device with a first electrode and a second electrode, particularly with a sensor device according to the present invention, with one hand, comprising at least the following steps:
- applying an alternating electrical signal to the second electrode, so that it emits an alternating electrical field,
- in a first operating mode, measuring the capacitive coupling between the first electrode and the second electrode and providing a first measuring signal,
- in a second operating mode, measuring the capacitive load of the second electrode against a reference ground and providing a second measuring signal,
wherein the measuring signals are indicative for the gripping of the hand-held device with the hand.

The measuring steps can be performed in parallel or sequentially.

The second measuring signal can be used to adjust the sensitivity of the sensor device in the first operating mode.

### Brief description of the drawings

Further details and features of the invention as well as further advantages of the invention can be found in the following description in combination with the drawings as follows:
- Fig. 1: a cell phone comprising a sensor device known from the state of the art for the approximation detection;
- Fig. 2: a sensor device according to the present invention with two sensor electrodes being operated in a first operating mode (transmission mode);
- Fig. 3: a sensor device according to the present invention with two sensor electrodes being operated in a second operating mode (loading mode), respectively;
- Fig. 4: a sensor device according to the present invention with two sensor electrodes being operated in a first operating mode as well as in a second operating mode;
- Fig. 5: the course of two sensor signals over time and depending on whether the electrical hand-held device is earthed or not, wherein a first sensor signal is assigned to the first operating mode and a second sensor signal is assigned to the second operating mode;
- Fig. 6: an example of implementation of a sensor device according to the present invention, which can be operated in a first operating mode as well as in a second operating mode;
- Fig. 7: the sensor device according to the present invention according to Fig. 6, furthermore comprising a compensating electrode; and
- Fig. 8: the sensor device according to the present invention according to Fig. 6, furthermore comprising two compensating electrodes.

### Detailed description of the invention

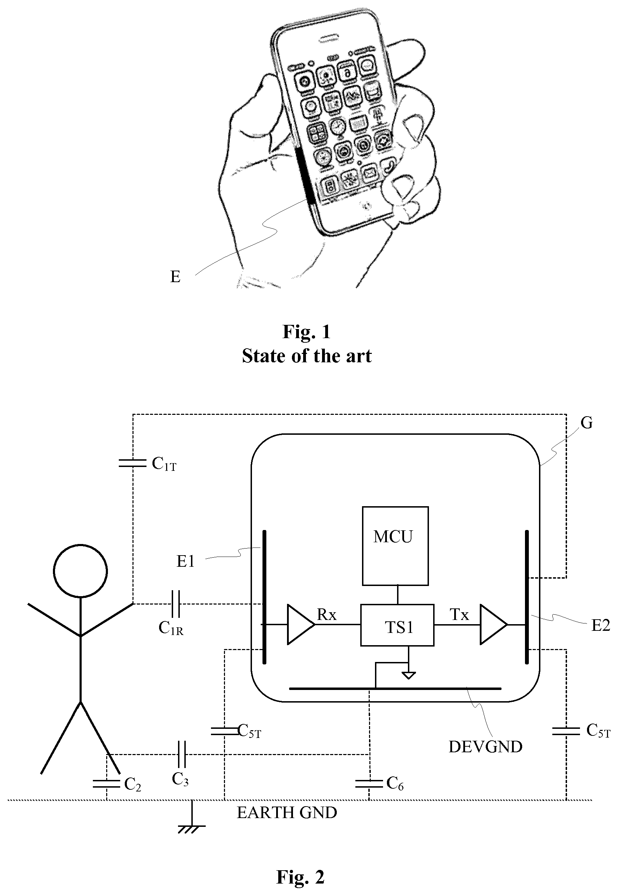

**Fig. 1** shows a cell phone comprising an approximation sensor known from the state of the art. Such an approximation sensor is, for example, known from the GB 2 398 138 A mentioned above. An electrode E of the approximation sensor is arranged at the left housing wall of the cell phone. When a hand approximates to the cell phone or to the electrode E, the capacity at the electrode E changes. This capacity change can be analyzed by an analysis device coupled with the electrode E. However, it is disadvantageous that particularly in case of battery-operated devices and in case of very low capacitive couplings between the hand of the user and the electrode E, the changes of the coupling capacity are also very small when the hand approximates to the electrode E, which could mean that an approximation is possibly not detected reliably.

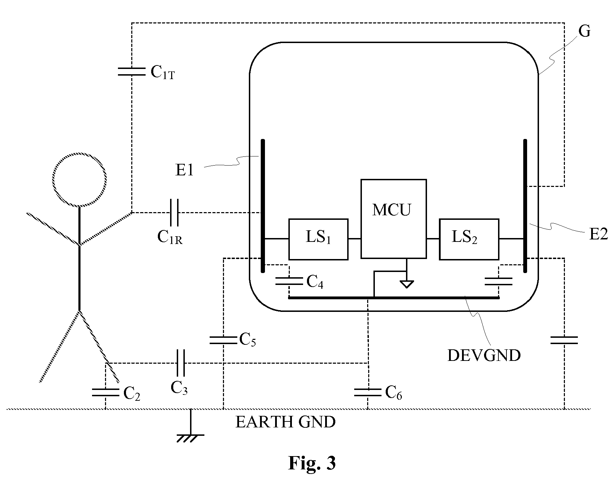

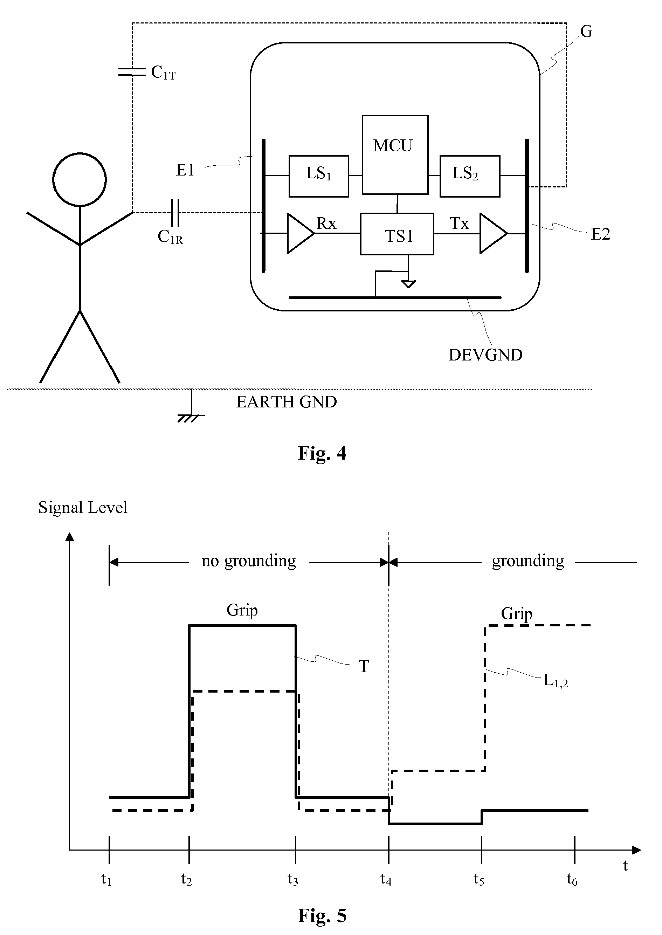

The invention is described in more detail below with reference to Fig. 2 to Fig. 8. According to the present invention, the sensor device is operated in a first operating mode and in a second operating mode. This enables a particularly reliable and precise detection of a gripping of a hand-held device with one hand. To begin with, the operation of the sensor device in a first operating mode is described with reference to Fig. 2 for further clarification of the sensor device according to the present invention. The sensor device according to the present invention is then described in a second operating mode with reference to Fig. 3. The sensor device according to the present invention being operated in the first operating mode as well as in the second operating mode is then described with reference to Fig. 4. The following Fig. 5 to Fig. 8 show further details for the implementation of a sensor device according to the present invention.

**Fig. 2** shows the sensor device according to the present invention being operated in a first operating mode. The first operating mode is hereinafter referred to as "transmission mode".

For the operation of the sensor device in the transmission mode, the sensor device comprises a sensor circuit TS1 and two electrodes E1 and E2 being coupled with the sensor circuit TS1. In the transmission mode, the electrode E2 is used as transmitting electrode and the electrode E1 is used as receiving electrode. The capacitive coupling between the two electrodes E1 and E2 is analyzed in the transmission mode.

For the operation of the sensor device in the transmission mode, an alternating electrical signal is applied to the electrode E2, so that it emits an alternating electrical field. When a hand approximates to the electrodes E1 und E2, the alternating electrical field emitted at the electrode E2 is coupled into the electrode E1 via the hand, so that a capacitive coupling is created between the electrode E2 and the electrode E1. In a further embodiment not shown here, such a (low) capacitive coupling can be created even if no hand approximates to the sensor device. However, the electrodes E1 and E2 are preferentially arranged relative to one another in such a way that if no hand approximates, no capacitive coupling is created between the electrodes E1 and E2.

The capacitive coupling between the two electrodes E1 and E2 changes with further approximation of the hand to the sensor device, so that a change of the coupling capacity between the electrodes E1 and E2 can be used as indicator for the approximation of a hand to the sensor device.

The equivalent circuit diagram according to Fig. 2 only considers the capacities substantial for the operation of the sensor device in the transmission mode. The operation of the sensor device according to the present invention in the transmission mode is particularly suitable for battery-operated devices, since in most cases there is no or only a very low coupling of the user to the ground of the device DEVGND and virtually no coupling of the device itself to ground.

However, if there is a capacitive coupling of the user to the ground of the device or of the device to ground or if this capacitive coupling becomes significant, the receiving signal at the electrode E1, i.e. the alternating electrical field coupled into the electrode E1, is considerably attenuated. A significant increase of the coupling of the device to ground can, for example, be created by connecting additional devices. This is the case, for example, with cell phones when they are connected with a charging device. The precision of the approximation detection or the detection of the gripping of a hand-held device with one hand can be reduced in the transmission mode by means of a significant coupling to ground.

**Fig. 3** shows a sensor device according to the present invention being operated in a second operating mode. The second operating mode is hereinafter referred to as "loading mode". When the sensor device according to the present invention is operated in the loading mode, a capacitive load between an electrode and a reference ground is used for detecting the approximation of a hand to the electrode.

A capacitive load means that the strength of an active electric field from the electrode to the reference ground is increased by the approximation of the electrically conductive hand and thus leads to an increase of the capacity between the electrode and the reference ground. The capacitive load is a measure of the strength of an active electric field from the electrode to the reference ground or a measure of the capacity between electrode and reference ground.

Thus, the capacity of the electrode is analyzed against a reference ground. It is characteristic of the loading mode that a transmitter and a receiver are connected to the same electrode.

The sensor device shown in Fig. 3 comprises two sensors, each being operated in the second operating mode, i.e. in the loading mode. The first sensor comprises a first sensor circuit LS1 and a sensor electrode E1 coupled with it. The second sensor comprises a second sensor circuit LS2 and a second sensor electrode E2 coupled with it. The two sensor circuits LS1, LS2 are each coupled with a microcontroller MCU, which preferentially processes or analyzes the sensor signals provided by the two sensor circuits LS1, LS2 and preferentially transmits unique sensor information to a master processing unit of an electrical device, such as a cell phone.

The operation of the sensor device according to the present invention in the loading mode is described with reference to the first sensor LS1, E1 as follows.

For the operation of the sensor LS1, E1, an alternating electrical signal is generated being applied to the sensor electrode E1. The generation of this alternating electrical signal can be performed by means known from the state of the art, such as a signal generator. Applying an alternating electrical signal to the sensor electrode E1 results in an alternating electrical field being emitted by the sensor electrode E1. When a hand approximates to the sensor electrode E1, the capacity between the sensor electrode E1 and the approximating hand increases, resulting in an increasing capacitive load of the electrode against the reference ground. The capacitive load is measured at the sensor circuit LS1. For example, the change of the capacitive load can be determined by the change of the load current via a shunt resistor.

When a hand approximates to the left side of the cell phone G or when the user touches the left side of the cell phone G, this increases the capacitive coupling between the user and the left electrode E1. The capacitive coupling between the electrode E1 and the user is indicated in Fig. 3 as concentrated capacity C_{1R}. A return current path can be created by a direct coupling of the user to the ground DEVGND of the cell phone G as well as by a coupling of the user to other conductive objects and to ground and the coupling back to the ground of the device DEVGND. The coupling of the user to the ground of the device is indicated as capacity C₃ in Fig. 3. The coupling of the user to other conductive objects and to ground is indicated as capacity C₂ and the coupling back to the ground of the device is indicated as capacity C₆ in Fig. 3.

A further capacitive load of the electrode E1 may also occur due to the coupling of the electrode E1 to ground, since it is in series with the capacity C₆. The capacity between the electrode E1 and ground is indicated as capacity C₅ in Fig. 3.

The capacities C₂ to C₆ are variables which may keep changing permanently. The change can be subject to the position, the way the person holds its hand etc. It has become evident that an additional load of the electrode E1 in case of the approximation of a hand to the electrode E1 or in case of a gripping the electrode E1 with the hand, the coupling capacity C_{1R} is the capacity mainly dominating for the signal change in the sensor LS1, since it is in series with the remaining load capacities C₂ to C₆ and it is low compared to them. This also means that the signal changes of the sensor device being operated in the loading mode remain substantially independent of different grounding situations.

By providing two sensors LS1, E1 or LS2, E2, each being operated in the loading mode, it advantageously possible to detect a gripping of the cell phone G. As a prerequisite for a reliable detection, the sensor electrode E1 and the sensor electrode E2 must be each arranged at the cell phone G in such a way that they are preferentially only covered by the hand when gripping the cell phone G. For example, the sensor electrode E1 can be arranged at the left side wall of a housing of the cell phone, the sensor electrode E2 can be arranged at the right housing wall of the cell phone G. As a matter of course, the electrodes E1 and E2 can also be arranged at different places on the cell phone housing, depending on the desired application.

However, for the detection of only the approximation of a hand to the cell phone, it is sufficient to provide only one of the two sensors, LS1, E1 or LS2, E2.

In order to ensure a more precise detection of the approximation or of a gripping of a hand-held device with one hand largely independent of the coupling to ground, the sensor device according to the present invention is operated in the first operating mode, i.e. in the transmission mode, as well as in the second operating mode, i.e. in the loading mode. A sensor device being operated in the first operating mode and in the second operating mode is described below in more detail with reference to Fig. 4.

**Fig. 4** shows a sensor device according to the present invention with two sensors, LS1, E1 and LS2, E2, being intended for the operation of the sensor device in the loading mode, and a sensor TS1, E1, E2, being intended for the operation of the sensor device in the transmission mode. The functioning of the sensor device according to the present invention in the loading mode has been described with reference to Fig. 3. The functioning of the sensor device in the transmission mode has been described with reference to Fig. 2.

As can be seen from Fig. 4, the electrodes E1 and E2 are used for the operation of the sensor device in the loading mode as well as for the operation of the sensor device in the transmission mode. As a matter of course, it is also possible to provide individual electrodes for each of the two operation modes. In addition to that, the sensor device according to the present invention can be operated in both operation modes when doing without one of the two sensor circuits LS1 or LS2 shown in Fig. 4.

For the functional description of the sensor device according to the present invention, which can be operated in both the operation modes, Fig. 4 only shows the active coupling capacity C_{1T} on the electrode E2 (transmitting electrode) and the active coupling capacity C_{1R} on the electrode E1 (receiving electrode). In case of an approximation or a gripping of the hand-held device with one hand, sensor signals are generated by the respective sensor circuits TS1 or LS1, LS2 in the transmission mode as well as in the loading mode. The sensor signals generated by the respective sensor circuits TS1, LS1 and LS2 may differ according to the embodiments of Fig. 2 and Fig. 3, depending on the coupling situation, particularly the coupling to ground.

**Fig. 5** shows a typical course of a sensor signal being provided by a sensor operated in the transmission mode and of a sensor signal being provided by a sensor operated in the loading mode over time. The temporal variation of the levels of the two sensor signals is shown for several load scenarios at different points in time. The signal T corresponds to the sensor signal of the sensor device in the transmission mode, the sensor signals L1, L2 correspond to the sensor signals of the sensor device in the loading mode. For a better illustration of the temporal variations of both signals, the sensor signal T is shown slightly offset with regard to the sensor signals L1, L2. In a specific case, the level changes of the sensor signal T and the sensor signals L1, L2 can also take place simultaneously.

The capacitive sensor device is not grounded between the points in time t1 and t4. These signal courses are plotted for a grounded sensor device between the points in time t4 and t6.

The sensor device according to the present invention is considered in the unloaded state of rest, i.e. without approximation of a hand to the sensor device or without gripping of a hand-held device with a sensor device with one hand, and in the ungrounded state between the points in time t1 and t2.

Between the points in time t2 and t3, there is an approximation of a hand to the sensor device or a gripping of a hand-held device with a sensor device with one hand without relevant coupling to ground. In this case, the sensor device in the transmission mode as well as the sensor device in the loading mode show a clear increase of the respective sensor signals T, L1, L2, wherein the two sensor subsystems LS1, LS2 provide almost identical sensor signals L1 and L2 in the loading mode.

At the point in time t3, the hand departs from the sensor device or the hand-held device is let go of. The levels again drop down to the initial values at the point in time t1.

At the point in time t4, a grounding of the hand-held device takes place, such as by connecting a charging device to the hand-held device. In this case, the signal being transmitted between the electrode E2 and the electrode E1 in the transmission mode is attenuated considerably due to the occurring coupling to ground described with reference to Fig. 2, so that a gripping of the hand-held device at the point in time t5 only results in a small change of level of the signal T. In contrast to this, the sensor signals L1, L2 significantly increase in the sensor circuits LS1, LS2 in the loading mode, since the grounding results in a higher capacitive load at the respective electrodes E1 and E2 (cf. Fig. 3).

Since the electrical hand-held devices, particularly the battery-operated devices, are mainly operated without relevant coupling to ground, the sensor signal T of the sensor device in the transmission mode is preferentially used for detecting an approximation to a hand-held device or a gripping of a hand-held device with one hand.

The sensor signals L1, L2 of the sensor device according to the present invention in the loading mode are preferentially used as reference signals for detecting a possible grounding situation. In case there is no grounding, the sensor signals L1, L2 can be used as redundant information on the sensor signal T, in order to ensure an increase of the detection reliability. In case of the grounding, the sensor signals L1, L2 in combination with the sensor signal T represent a recognition criterion for the grounding, so that the sensor device according to the present invention can be switched to a higher sensitivity in the transmission mode.

The correlation of the sensor signals can be effected, for example, by a ratio L1/T or L2/T or also (L1 + L2)/T of the sensor signals L1, L2 and the sensor signal T. In the ungrounded case, this ratio remains nearly constant, whereas it significantly increases in the grounded case due to the levels shown in Fig. 5 and thus provides information on the grounding state.

This way, the sensor device can be adjusted in the transmission mode. For example, the amplitude of the alternating signal applied to the electrode E2 can be scaled up or down, depending on the capacitive load of the electrodes in the loading mode. As an alternative or in addition to that, the threshold values for an approximation or touch detection in the transmission mode can be adjusted, depending on the sensor signals L1 and/or L2.

The combination of the sensor signals L1, L2 with the sensor signal T thus provides increased detection reliability in numerous application scenarios.

A sensor device according to the present invention shown in Fig. 4 provides an approximation of a user to a hand-held device or a gripping of a hand-held device with one hand with a low error rate with regard to detection and rejection as well as substantially independent of the coupling to ground.

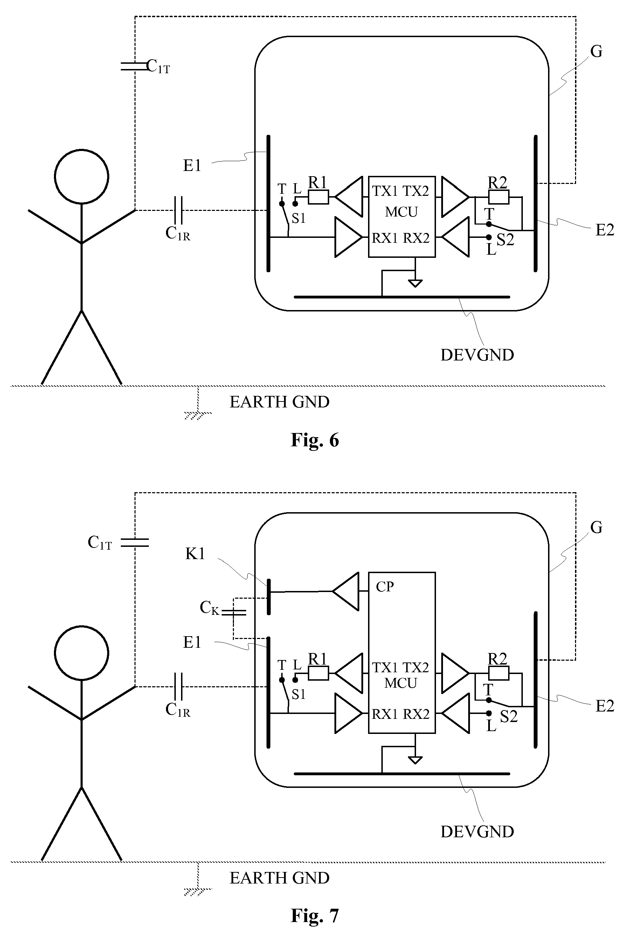

**Fig. 6** shows an example of implementation of a sensor device according to the present invention, which can be operated in a first operating mode, i.e. in a transmission mode, as well as in a second operating mode, i.e. in a loading mode.

In the switch position T, the sensor device according to the present invention is in the transmission mode, i.e. the capacitive coupling between the electrode E2 and the electrode E1 is measured and analyzed. In the switch position L, the sensor device according to the present invention is in the loading mode, i.e. the capacitive load at the electrode E1 (with TX1 and RX1) and the capacitive load at the electrode E2 (with TX2 and RX2) is measured and analyzed.

The sensor device can, for example, be operated cyclically in one of the two operating modes by means of the two switches S1, S2. In the loading mode, the grounding or the coupling to ground of the capacitive sensor device can be detected and analyzed. The result of the analysis can be considered for the subsequent operation of the sensor device in the transmission mode. For example, the alternating electrical signal applied to the transmitting electrode E2 can be adjusted, depending on the capacitive load of the sensors in the loading mode. However, a threshold value can also be adjusted for the analysis of a second measuring in the transmission mode.

However, the sensor device according to the present invention can also be operated in parallel or virtually parallel in the loading mode and in the transmission mode.

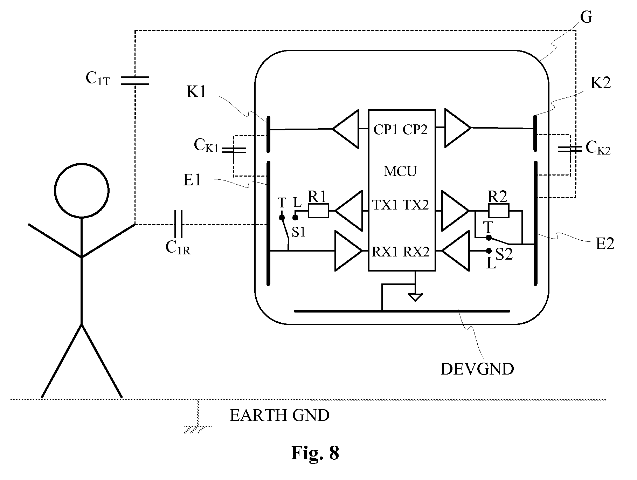

Fig. 7 and 8 show two more examples of implementation of a sensor device according to the present invention.

**Fig. 7** provides an additional electrode K1, which is used as compensating electrode of the sensor device in the transmission mode. An alternating electrical signal is applied to the compensating electrode K1, preferentially having a phase and/or amplitude differing from the phase and/or amplitude of the alternating electrical signal applied to the electrode E1.

The compensating electrode K1 is arranged relative to the electrode E1 in such a way that the alternating electrical field emitted at the compensating electrode K1 couples into the receiving electrode E1. This way, a compensation of the capacitive environment of the hand-held device is achieved at least in the area of the receiving electrode E1.

When gripping the hand-held device with one hand, the alternating electrical field emitted at the transmitting electrode E2 in the transmission mode couples into the receiving electrode E1 via the hand. This way, the alternating electrical field emitted at the compensating electrode K1 is "bridged". The alternating electrical field coupled into the receiving electrode E1 is used as a measure of the gripping of the hand-held device with one hand.

**Fig. 8** shows the sensor device according to Fig. 7, comprising a second compensating electrode K2 in addition to the compensating electrode K1. The compensating electrode K2 is arranged relative to the transmitting electrode E2 in such a way that an alternating electrical field emitted at the compensating electrode K2 can couple into the transmitting electrode E2.

When in operation, an alternating electrical field is emitted at each of the electrodes E2, K2 and K1 when gripping the electrical hand-held device with one hand in the transmission mode (switch position T of the two switches S1 and S2), which couple into the receiving electrode E1 via the hand. The alternating electrical fields emitted at the compensating electrodes K2 and K1 enable a compensation of the capacitive environment at both sides of the housing.

Furthermore, a complete system test can be performed by means of the compensating electrodes K1 and K2. The system test can be performed prior to starting the measuring mode. The system test can also be performed at cyclical intervals in order to enable a calibration of the sensor device during operation.

The system test completely checks the microcontroller MCU, the supply lines and the electrodes. For this, the switches S1 and S2 are brought into the switch position L. An alternating electrical signal (test signal) is applied to the compensating electrode K1 and a receiving signal is tapped at the receiving electrode E1, which can be tested for compliance with pre-defined tolerances. Likewise, an alternating electrical signal (test signal) is applied to the compensating electrode K2 and a receiving signal is tapped at the electrode E2, which functions as receiving electrode in the system test. This receiving signal can also be tested for compliance with pre-defined tolerances.

According to the present invention, also several sensor devices according to the present invention can be provided at one hand-held device, in order to, for example, detect different positions of the hand at the hand-held device when gripping the hand-held device with the hand.

In a further development of the invention, the sensor device may comprise one transmitting electrode E2 and several receiving electrodes E1 in the transmission mode. It may also comprise several transmitting electrodes E2 and one receiving electrode E1. In a further embodiment, the sensor device may also comprise several transmitting electrodes E2 and several receiving electrodes E1 in the transmission mode. In case of several transmitting electrodes E2, a different alternating electrical signal can be applied to each transmitting electrode E2 so that different alternating electrical fields are coupled into the receiving electrode E1 via the hand, depending on the position of the gripping hand. The alternating electrical fields coupled into the receiving electrode E1 can be separated and be assigned to the respective transmitting electrode E2.

For the loading mode, the sensor device may also comprise more than two electrodes. For example, the sensor circuit LS1 of the sensor device shown in Fig. 3 may comprise additional electrodes. This also applies to the sensor circuit LS2 shown in Fig. 4.

A cell phone has been described above representative for an electrical hand-held device. A hand-held device, which can be provided with a sensor device according to the present invention, can also be a computer mouse, a remote control for a device, a digital camera, a game controller or the like.

## Claims

1. A sensor device comprising at least one first electrode (E1) and at least one second electrode (E2) being coupled with an analysis device (LS1, LS2, TS1, MCU), wherein
- the at least one first electrode (E1) is configured to be operated in a first operating mode (TM) in which the at least one first electrode (E1) operates as a receiving electrode,
- the at least one second electrode (E2) is configured to be operated in said first operating mode (TM) in which the at least one second electrode (E2) operates as a transmitting electrode and in a second operating mode (LM) in which the at least one second electrode (E2) operates as a combined transmitting and receiving electrode,
- in the first operating mode (TM), the analysis device (TS1, MCU) is configured to analyse the capacitive coupling between the at least one first electrode (E1) and the at least one second electrode (E2) and
- in the second operating mode (LM), the analysis device (LS2, MCU) is configured to analyse a capacitive load of the at least one second electrode (E2) against a reference ground.

2. Sensor device according to claim 1, wherein the at least one first electrode (E1) is further configured to be operated in the second operating mode (LM) in which the at least one first electrode (E1) operates as a combined transmitting and receiving electrode and wherein in the second operating mode (LM), furthermore the analysis device (LS1, MCU) is configured to analyse a capacitive load of the at least one first electrode (E1) against a reference ground (DEVGND).

3. Sensor device according to claim 1 or 2, wherein an electrical alternating signal is applied to the second electrode (E2) in the first operating mode (TM) and in the second operating mode (LM), wherein the capacitive coupling between the first electrode (E1) and the second electrode (E2) is represented by the electric current flowing in the first electrode (E1).

4. Sensor device according to one of the preceding claims, wherein the analysis device is configured to provide a sensor signal each in the first operating mode (TM) and in the second operating mode (LM), which is indicative for the capacitive coupling between the first electrode (E1) and the second electrode (E2) or for the capacitive load of the first electrode (E1) and/or the second electrode (E2), respectively.

5. Sensor device according to one of the preceding claims, further comprising a third electrode (K1), wherein an alternating electrical signal, having a phase and/or amplitude differing from the phase and/or the amplitude of the alternating electrical signal applied to the second electrode (E2), is applied to the third electrode (K1).

6. Sensor device according to one of the claims 1 to 4, further comprising a third electrode (K1) and a fourth electrode (K2), wherein each receives an alternating electrical signal, wherein the third electrode (K1) is arranged to provide a capacitive coupling with the first electrode (E1) and the fourth electrode (K2) is arranged to provide a capacitive coupling with the second electrode (E2), wherein the sensor device is operated in a third operating mode (KM), wherein the analysis device is configured to analyse the capacitive couplings between the first electrode (E1) and the third electrode (K1) and between the second electrode (E2) and the fourth electrode (K2).

7. A hand-held device (G), in particular a computer mouse, remote control for device, digital camera or game controller, comprising at least one sensor device according to one of the preceding claims.

8. Hand- held device according to claim 7, wherein the first electrode (E1) and the second electrode (E2) are arranged relative to one another on the hand- held device in such a way that they are at least partially overlapped by a hand when gripping the hand-held device with one hand.

9. Hand- held device according to claim 8, wherein the first electrode (E1) and the second electrode (E2) are arranged at two walls facing each other, preferably at two side walls of a housing of the hand-held device facing each other.

10. A method for the detection of the gripping of a hand-held device (G) with a first electrode (E1) and a second electrode (E2), particularly with a sensor device according to one of the claims 1 to 6, with one hand, comprising at least the following steps:
- applying an alternating electrical signal to the second electrode (E2) wherein an alternating electrical field is emitted from the second electrode (E2),
- in a first operating mode (TM), measuring the capacitive coupling between the first electrode (E1) and the second electrode (E2) by measuring the signal received at the first electrode (E1) and providing a first measuring signal (T),
- in a second operating mode (LM), measuring the capacitive load of the second electrode (E2) against a reference ground (DEVGND) by measuring the signal applied to the second electrode (E2) and providing a second measuring signal (LI, L2),
wherein the measuring signals are indicative for the gripping of the handheld device with the hand.

11. Method according to claim 10, wherein an alternating electrical signal is applied to the first electrode (E1) in the second operating mode, wherein an alternating electrical field is emitted from the first electrode (E1) and the capacitive load of the first electrode (E1) is measured by measuring the signal applied to the first electrode (E2).

12. Method according to claim 10 or 11, wherein the amplitude of the alternating electrical signal applied to the second electrode (E2) in the first operating mode is adjusted, depending on the capacitive load of the electrodes as determined in the second operating mode (LM).

13. Method according to one of the claims 10-12, wherein the second measuring signal is used to adjust the sensitivity of the sensor device in the first operating mode (TM).

14. Method according to one of the claims 10-13, wherein an alternating electrical signal is applied to a first compensating electrode (K1) in the first operating mode and wherein the alternating electrical signal applied to the first compensating electrode has a phase and/or amplitude differing from the phase and/or amplitude of the alternating electrical signal applied to the first electrode (E1).

15. Method according to one of the claims 10-14, wherein an alternating electrical signal is applied to each of the one first compensating electrode (K1) and the one second compensating electrode (K2), so that the first compensating electrode (K1) can be brought into a capacitive coupling with the first electrode (E1) and the second compensating electrode (K2) can be brought into a capacitive coupling with the second electrode (E2), wherein the sensor device is operated in a third operating mode (KM), wherein the capacitive couplings between the first electrode (E1) and the first compensating electrode (K1) and between the second electrode (E2) and the second compensating electrode (K2) are analyzed by the analysis device.

## Patentansprüche

1. Sensorvorrichtung, die zumindest eine erste Elektrode (E1) und zumindest eine zweite Elektrode (E2) aufweist, die mit einer Auswertevorrichtung (LS1, LS2, TS1, MCU) gekoppelt sind, wobei
- die zumindest eine erste Elektrode (E1) konfiguriert ist in einem ersten Betriebsmodus (TM) betrieben zu werden, in dem die zumindest eine erste Elektrode (E1) als eine Empfangselektrode arbeitet,
- die zumindest eine zweite Elektrode (E2) konfiguriert ist in dem ersten Betriebsmodus (TM) betrieben zu werden, in dem die zumindest eine zweite Elektrode (E2) als eine Sendeelektrode arbeitet, und in einem zweiten Betriebsmodus (LM), in dem die zumindest eine zweite Elektrode (E2) als eine kombinierte Sende- und Empfangselektrode arbeitet,
- in dem ersten Betriebsmodus (TM) die Auswertevorrichtung (TS1, MCU) konfiguriert ist die kapazitive Kopplung zwischen der zumindest einen ersten Elektrode (E1) und der zumindest einen zweiten Elektrode (E2) auszuwerten, und
- in dem zweiten Betriebsmodus (LM) die Auswertevorrichtung (LS2, MCU) konfiguriert ist eine kapazitive Ladung der zumindest einen zweiten Elektrode (E2) gegenüber einer Referenzmasse auszuwerten.

2. Sensorvorrichtung gemäß Anspruch 1, wobei die zumindest eine erste Elektrode (E1) weiterhin konfiguriert ist, in dem zweiten Betriebsmodus (LM) betrieben zu werden, in dem die zumindest eine erste Elektrode (E1) als eine kombinierte Sende- und Empfangselektrode arbeitet und wobei in dem zweiten Betriebsmodus (LM) die Auswertevorrichtung (LS 1, MCU) weiterhin konfiguriert ist, eine kapazitive Ladung der zumindest einen ersten Elektrode (E1) gegenüber einer Referenzmasse (DEVGND) auszuwerten.

3. Sensorvorrichtung gemäß Anspruch 1 oder 2, wobei in dem ersten Betriebsmodus (TM) und in dem zweiten Betriebsmodus (LM) ein elektrisches Wechselsignal an die zweite Elektrode (E2) angelegt wird, wobei die kapazitive Kopplung zwischen der ersten Elektrode (E1) und der zweiten Elektrode (E2) durch den elektrischen Strom repräsentiert wird, der in der ersten Elektrode (E1) fließt.

4. Sensorvorrichtung gemäß einem der vorherigen Ansprüche, wobei die Auswertevorrichtung konfiguriert ist, jeweils in dem ersten Betriebsmodus (TM) und in dem zweiten Betriebsmodus (LM) ein Sensorsignal zur Verfügung zu stellen, welches für die kapazitive Kopplung zwischen der ersten Elektrode (E1) und der zweiten Elektrode (E2) oder für die kapazitive Ladung jeweils der ersten Elektrode (E1) und/oder der zweiten Elektrode (E2) bezeichnend ist.

5. Sensorvorrichtung gemäß einem der vorherigen Ansprüche, die weiterhin eine dritte Elektrode (K1) aufweist, wobei ein elektrisches Wechselsignal, das eine Phase und/oder Amplitude aufweist die sich von der Phase und/oder der Amplitude des an die zweite Elektrode (E2) angelegten elektrischen Wechselsignals unterscheidet, an die dritte Elektrode (K1) angelegt wird.

6. Sensorvorrichtung gemäß einem der Ansprüche 1 bis 4, die weiterhin eine dritte Elektrode (K1) und eine vierte Elektrode (K2) aufweist, wobei jede ein elektrisches Wechselsignal empfängt, wobei die dritte Elektrode (K1) angeordnet ist, um eine kapazitive Kopplung mit der ersten Elektrode (E1) zur Verfügung zu stellen und die vierte Elektrode (K2) angeordnet ist, um eine kapazitive Kopplung mit der zweiten Elektrode (E2) zur Verfügung zu stellen, wobei die Sensorvorrichtung in einem dritten Betriebsmodus (KM) betrieben wird, wobei die Auswertevorrichtung konfiguriert ist, die kapazitiven Kopplungen zwischen der ersten Elektrode (E1) und der dritten Elektrode (K1) und zwischen der zweiten Elektrode (E2) und der vierten Elektrode (K2) auszuwerten.

7. Tragbare Vorrichtung (G), im Besonderen eine Computermaus, Fernbedienung für eine Vorrichtung, digitale Kamera oder Computerspielsteuerung, die zumindest eine Sensorvorrichtung gemäß einem der vorherigen Ansprüche aufweist.

8. Tragbare Vorrichtung gemäß Anspruch 7, wobei die erste Elektrode (E1) und die zweite Elektrode (E2) an der tragbaren Vorrichtung relativ zueinander auf eine solche Weise angeordnet sind, dass sie zumindest teilweise durch eine Hand überdeckt werden, wenn die tragbare Vorrichtung mit einer Hand ergriffen wird.

9. Tragbare Vorrichtung gemäß Anspruch 8, wobei die erste Elektrode (E1) und die zweite Elektrode (E2) an zwei einander gegenüber liegenden Seiten angeordnet sind, vorzugsweise an zwei Längsseiten eines Gehäuses der tragbaren Vorrichtung, die einander gegenüber liegen.

10. Verfahren zur Erkennung des Ergreifens einer tragbaren Vorrichtung (G) mit einer Hand mit einer ersten Elektrode (E1) und einer zweiten Elektrode (E2), im Besonderen mit einer Sensorvorrichtung gemäß einem der Ansprüche 1 bis 6, das zumindest die folgenden Schritte aufweist:
- Anlegen eines elektrischen Wechselsignals an die zweite Elektrode (E2), wobei ein elektrisches Wechselfeld von der zweiten Elektrode (E2) emittiert wird,
- in einem ersten Betriebsmodus (TM), Messen der kapazitiven Kopplung zwischen der ersten Elektrode (E1) und der zweiten Elektrode (E2) durch Messen des an der ersten Elektrode (E1) empfangenen Signals und Bereitstellen eines ersten Messsignals (T),
- in einem zweiten Betriebsmodus (LM), Messen der kapazitiven Kopplung der zweiten Elektrode (E2) gegen eine Referenzmasse (DEVGND) durch Messen des an die zweite Elektrode (E2) angelegten Signals und Bereitstellen eines zweiten Messsignals (L1, L2),
wobei die Messsignale bezeichnend sind für das Ergreifen der tragbaren Vorrichtung mit der Hand.

11. Verfahren gemäß Anspruch 10, wobei in dem zweiten Betriebsmodus ein elektrisches Wechselsignal an die erste Elektrode (E1) angelegt wird, wobei ein elektrisches Wechselfeld von der ersten Elektrode (E1) emittiert wird und die kapazitive Ladung der ersten Elektrode (E1) durch Messen des an die zweite Elektrode (E2) angelegten Signals gemessen wird.

12. Verfahren gemäß Anspruch 10 oder 11, wobei die Amplitude des an die zweite Elektrode (E2) angelegten elektrischen Wechselsignals in dem ersten Betriebsmodus in Abhängigkeit von der kapazitiven Ladung der Elektroden abgeglichen wird, wie diese in dem zweiten Betriebsmodus (LM) ermittelt wurde.

13. Verfahren gemäß einem der Ansprüche 10 bis 12, wobei das zweite Messsignal verwendet wird, um die Empfindlichkeit der Sensorvorrichtung in dem ersten Betriebsmodus (TM) abzugleichen.

14. Verfahren gemäß einem der Ansprüche 10 bis 13, wobei in dem ersten Betriebsmodus ein elektrisches Wechselsignal an eine erste Kompensationselektrode (K1) angelegt wird und wobei das an die erste Kompensationselektrode angelegte elektrisches Wechselsignal eine Phase und/oder Amplitude aufweist, die sich von der Phase und/oder Amplitude des an die erste Elektrode (E1) angelegten elektrischen Wechselsignals unterscheiden.

15. Verfahren gemäß einem der Ansprüche 10 bis 14, wobei ein elektrisches Wechselsignal an jede der einen ersten Kompensationselektrode (K1) und der einen zweiten Kompensationselektrode (K2) angelegt wird, so dass die erste Kompensationselektrode (K1) mit der ersten Elektrode (E1) in eine kapazitive Kopplung gebracht werden kann und die zweite Kompensationselektrode (K2) mit der zweiten Elektrode (E2) in eine kapazitive Kopplung gebracht werden kann, wobei die Sensorvorrichtung in einem dritten Betriebsmodus (KM) betrieben wird, wobei die kapazitiven Kopplungen zwischen der ersten Elektrode (E1) und der ersten Kompensationselektrode (K1) und zwischen der zweiten Elektrode (E2) und der zweiten Kompensationselektrode (K2) durch die Auswertevorrichtung ausgewertet werden.

## Revendications

1. Dispositif de détection comprenant au moins une première électrode (E1) et au moins une deuxième électrode (E2) couplée à un dispositif d'analyse (LS1, LS2, TS1, MCU), dans lequel :
- la ou les premières électrodes (E1) sont configurées de façon à être actionnées dans un premier mode de fonctionnement (TM) dans lequel la ou les premières électrodes (E1) fonctionnent en tant qu'électrode de réception ;
- la ou les deuxièmes électrodes (E2) sont configurées de façon à être actionnées dans ledit premier mode de fonctionnement (TM) dans lequel la ou les deuxièmes électrodes (E2) fonctionnent en tant qu'électrode d'émission, et dans un deuxième mode de fonctionnement (LM) dans lequel la ou les deuxièmes électrodes (E2) fonctionnent en tant qu'électrode d'émission et de réception combinée ;
- dans le premier mode de fonctionnement (TM), le dispositif d'analyse (TS1, MCU) est configuré de façon à analyser le couplage capacitif entre la ou les premières électrodes (E1) et la ou les deuxièmes électrodes (E2) ; et
- dans le deuxième mode de fonctionnement (LM), le dispositif d'analyse (LS2, MCU) est configuré de façon à analyser la charge capacitive de la ou des deuxièmes électrodes (E2) par rapport à une masse de référence.

2. Dispositif de détection selon la revendication 1, dans lequel la ou les premières électrodes (E1) sont configurées en outre de façon à être actionnées dans le deuxième mode de fonctionnement (LM) dans lequel la ou les premières électrodes (E1) fonctionnent en tant qu'électrode d'émission et de réception combinée, et dans lequel, dans le deuxième mode de fonctionnement (LM), en outre, le dispositif d'analyse (LS1, MCU) est configuré de façon à analyser la charge capacitive de la ou des premières électrodes (E1) par rapport à une masse de référence (DEVGND).

3. Dispositif de détection selon la revendication 1 ou la revendication 2, dans lequel un signal alternatif électrique est appliqué à la deuxième électrode (E2) dans le premier mode de fonctionnement (TM) et dans le deuxième mode de fonctionnement (LM), dans lequel le couplage capacitif entre la première électrode (E1) et la deuxième électrode (E2), est représenté par le courant électrique qui circule dans la première électrode (E1).

4. Dispositif de détection selon l'une quelconque des revendications précédentes, dans lequel le dispositif d'analyse est configuré de façon à fournir un signal de détection dans le premier mode de fonctionnement (TM) et dans le deuxième mode de fonctionnement (LM), qui est indicatif du couplage capacitif entre la première électrode (E1) et la deuxième électrode (E2), ou de la charge capacitive de la première électrode (E1) et / ou de la deuxième électrode (E2), respectivement.

5. Dispositif de détection selon l'une quelconque des revendications précédentes, comprenant en outre une troisième électrode (K1), dans lequel un signal électrique alternatif, qui présente une phase et / ou une amplitude qui diffèrent de la phase et / ou de l'amplitude du signal électrique alternatif appliqué à la deuxième électrode (E2), est appliqué à la troisième électrode (K1).

6. Dispositif de détection selon l'une quelconque des revendications 1 à 4, comprenant en outre une troisième électrode (K1) et une quatrième électrode (K2), dans lequel chacune d'elles reçoit un signal électrique alternatif, dans lequel la troisième électrode (K1) est agencée de façon à fournir un couplage capacitif avec la première électrode (E1), et la quatrième électrode (K2) est agencée de façon à fournir un couplage capacitif avec la deuxième électrode (E2), dans lequel le dispositif de détection est actionné dans un troisième mode de fonctionnement (KM), dans lequel le dispositif d'analyse est configuré de façon à analyser les couplages capacitifs entre la première électrode (E1) et la troisième électrode (K1), et entre la deuxième électrode (E2) et la quatrième électrode (K2).

7. Dispositif portable (G), en particulier une souris d'ordinateur, une télécommande dans dispositif, un appareil photo numérique ou un contrôleur de jeu, comprenant au moins un dispositif de détection selon l'une quelconque des revendications précédentes.

8. Dispositif portable selon la revendication 7, dans lequel la première électrode (E1) et la deuxième électrode (E2) sont agencées l'une par rapport à l'autre sur le dispositif portable de telle manière qu'elles soient couvertes en partie au moins par une main lors de la préhension du dispositif portable avec une main.

9. Dispositif portable selon la revendication 8, dans lequel la première électrode (E1) et la deuxième électrode (E2) sont agencées au niveau de deux parois qui se font face l'une à l'autre, de préférence au niveau de deux parois latérales du logement du dispositif portable qui se font face l'une à l'autre.

10. Procédé de détection de la préhension d'un dispositif portable (G) avec une première électrode (E1) et une deuxième électrode (E2), en particulier avec un dispositif de détection selon l'une quelconque des revendications 1 à 6, avec une main, comprenant au moins les étapes suivantes consistant à :
- appliquer un signal électrique alternatif à la deuxième électrode (E2) dans lequel un champ électrique alternatif est émis à partir de la deuxième électrode (E2) ;
- dans un premier mode de fonctionnement (TM), mesurer le couplage capacitif entre la première électrode (E1) et la deuxième électrode (E2) en mesurant le signal reçu au niveau de la première électrode (E1), et fournir un premier signal de mesure (T) ;
- dans un deuxième mode de fonctionnement (LM), mesurer la charge capacitive de la deuxième électrode (E2) par rapport à une masse de référence (DEVGND) en mesurant le signal appliqué à la deuxième électrode (E2) et en fournissant un deuxième signal de mesure (L1, L2) ;
dans lequel les signaux de mesure sont indicatifs de la préhension du dispositif portable avec la main.

11. Procédé selon la revendication 10, dans lequel un signal électrique alternatif est appliqué à la première électrode (E1) dans le deuxième mode de fonctionnement, dans lequel un champ électrique alternatif est émis à partir de la première électrode (E1), et la charge capacitive de la première électrode (E1) est mesurée en mesurant le signal appliqué à la deuxième électrode (E2).

12. Procédé selon la revendication 10 ou la revendication 11, dans lequel l'amplitude du signal électrique alternatif appliqué à la deuxième électrode (E2) dans le premier mode de fonctionnement est réglée, selon la charge capacitive des électrodes comme cela est déterminé dans le deuxième mode de fonctionnement (LM).

13. Procédé selon l'une quelconque des revendications 10 à 12, dans lequel le deuxième signal de mesure est utilisé de façon à régler la sensibilité du dispositif de détection dans le premier mode de fonctionnement (TM).

14. Procédé selon l'une quelconque des revendications 10 à 13, dans lequel un signal électrique alternatif est appliqué à une première électrode de compensation (K1) dans le premier mode de fonctionnement, et dans lequel le signal électrique alternatif appliqué à la première électrode de compensation présente une phase et / ou une amplitude qui diffèrent de la phase et / ou de l'amplitude du signal électrique alternatif appliqué à la première électrode (E1).

15. Procédé selon l'une quelconque des revendications 10 à 14, dans lequel un signal électrique alternatif est appliqué à chacune de la première électrode de compensation (K1) et de la deuxième électrode de compensation (K2), de telle sorte que la première électrode de compensation (K1) puisse être amenée à un couplage capacitif avec la première électrode (E1), et que la deuxième électrode de compensation (K2) puisse être amenée à un couplage capacitif avec la deuxième électrode (E2), dans lequel le dispositif de détection est actionné dans un troisième mode de fonctionnement (KM), dans lequel les couplages capacitifs entre la première électrode (E1) et la première électrode de compensation (K1), et entre la deuxième électrode (E2) et la deuxième électrode de compensation (K2), sont analysés par le dispositif d'analyse.
